# EUROPEAN PATENT APPLICATION

(11) **EP 4 654 070 A1**
(43) Date of publication of application: **26.11.2025**
(21) Application number: 25178136.5
(22) Date of filing: 22.05.2025
(51) Int. Cl.: G06F 30/27, G06F 30/17

(54) **NOVEL DATA TYPE FOR N-DIMENSIONAL REPRESENTATION OF OBJECTS WITH ULTRA-RICH CONTENTS**

(30) Priority: 24.05.2024 US 202463651565 P
(71) Applicant: The Boeing Company, Arlington, VA 22202 (US)
(72) Inventor: AFRASIABI, Amir, Arlington, 22202 (US); RAFATI, Sina, Arlington, 22202 (US)
(74) Representative: Bugnion S.p.A. - US1

(57) **Abstract**

Generating data enriched voxels is provided. The method comprises receiving image data of a three-dimensional (3D) object. A number of key vertices are detected within the 3D object, and a bill of materials (BOM) is created for each key vertex. The BOM for each key vertex is then enriched with production data and sensor data, wherein the enriched BOM for each key vertex describes environmental conditions within a defined area around the 3D object. The enriched BOM for each key vertex are then fed into a respective neural network that generates a two-dimensional (2D) pixel containing all data from the enriched BOM, wherein the 2D pixel forms part of a tensor of 2D pixels.

## Description

### BACKGROUND INFORMATION

### Technical Field:

The present disclosure relates generally to data processing, and more specifically to the integration of different data types into a coherent format.

### Background:

Existing data formats often focus on a single dimension such as, e.g., visual data, temporal information, or thermal imaging. However, many real-world applications demand a synthesis of such dimensions to comprehend scenarios. For example, autonomous vehicle navigation might require images, precise timestamps, thermal data, and tracking in six degrees of freedom to accurately interpret surroundings, especially in low-light conditions or challenging environments.

### SUMMARY

An illustrative embodiment provides a computer-implemented method for generating data enriched voxels. The method comprises receiving image data of a three-dimensional (3D) object. A number of key vertices are detected within the 3D object, and a bill of materials (BOM) is created for each key vertex. The BOM for each key vertex is then enriched with production data and sensor data, wherein the enriched BOM for each key vertex describes environmental conditions within a defined area around the 3D object. The enriched BOM for each key vertex are then fed into a respective neural network that generates a two-dimensional (2D) pixel containing all data from the enriched BOM, wherein the 2D pixel forms part of a tensor of 2D pixels.

Another illustrative embodiment provides a system for generating data enriched voxels. The system comprises a storage device that stores program instructions and one or more processors operably connected to the storage device and configured to execute the program instructions to cause the system to: receive image data of a three-dimensional (3D) object; detect a number of key vertices within the 3D object; create a bill of materials (BOM) for each key vertex; enrich the BOM for each key vertex with production data and sensor data, wherein the enriched BOM for each key vertex describes environmental conditions within a defined area around the 3D object; and feed the enriched BOM for each key vertex into a respective neural network that generates a two-dimensional (2D) pixel containing all data from the enriched BOM, wherein the 2D pixel forms part of a tensor of 2D pixels.

Another illustrative embodiment provides a computer program product for generating data enriched voxels. The computer program product comprises a computer-readable storage medium having program instructions embodied thereon to perform the steps of: receiving image data of a three-dimensional (3D) object; detecting a number of key vertices within the 3D object; creating a bill of materials (BOM) for each key vertex; enriching the BOM for each key vertex with production data and sensor data, wherein the enriched BOM for each key vertex describes environmental conditions within a defined area around the 3D object; and feeding the enriched BOM for each key vertex into a respective neural network that generates a two-dimensional (2D) pixel containing all data from the enriched BOM, wherein the 2D pixel forms part of a tensor of 2D pixels.

The features and functions can be achieved independently in various embodiments of the present disclosure or may be combined in yet other embodiments in which further details can be seen with reference to the following description and drawings.

### BRIEF DESCRIPTION OF THE DRAWINGS

The novel features believed characteristic of the illustrative embodiments are set forth in the appended claims. The illustrative embodiments, however, as well as a preferred mode of use, further objectives and features thereof, will best be understood by reference to the following detailed description of an illustrative embodiment of the present disclosure when read in conjunction with the accompanying drawings, wherein:
**Figure 1** depicts a block diagram of daxle system in accordance with an illustrative embodiment;
**Figure 2** depicts a diagram illustrating the relationship between different dimensional data representations in accordance with an illustrative embodiment;
**Figure 3** depicts a diagram illustrating the contrast between pixel and daxle data representation in accordance with an illustrative embodiment;
**Figure 4** depicts a diagram illustrating a temporal representation of an N-dimensional data format in accordance with an illustrative embodiment;
**Figure 5** depicts an example of a 3D CAD object from which a daxle can be generated in accordance with an illustrative embodiment;
**Figure 6** depicts a table for creating a bill of materials for each key vertex of the 3D object in accordance with an illustrative embodiment;
**Figure 7** depicts temporal stacking of N-dimensional daxle data in accordance with an illustrative embodiment;
**Figure 8** depicts a diagram illustrating digestion of daxle data and its subsequent use in machine learning in accordance with an illustrative embodiment;
**Figure 9** depicts a flowchart illustrating a process for generating data enriched voxels in accordance with an illustrative embodiment; and
**Figure 10** is an illustration of a block diagram of a data processing system in accordance with an illustrative embodiment.

### DETAILED DESCRIPTION

The illustrative embodiments recognize and take into account that existing data formats often focus on a single dimension such as, e.g., visual data, temporal information, or thermal imaging. However, many real-world applications demand a synthesis of such dimensions to comprehend scenarios.

The illustrative embodiments provide a data structure that encapsulates high-resolution images, accurate timestamps, thermal imaging layers, and 6 DOF tracking information within a single cohesive package.

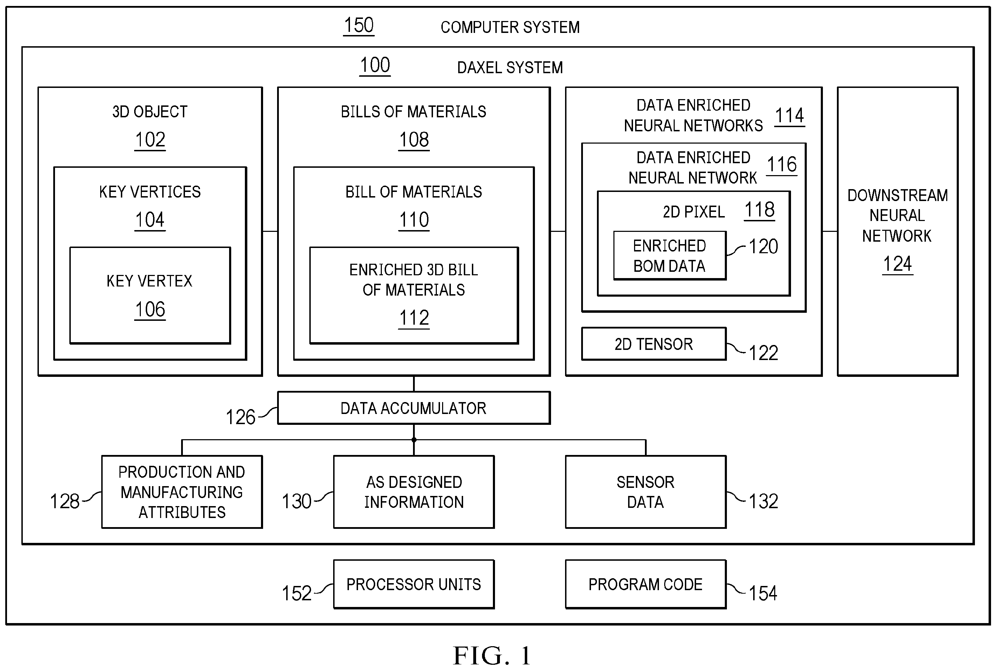

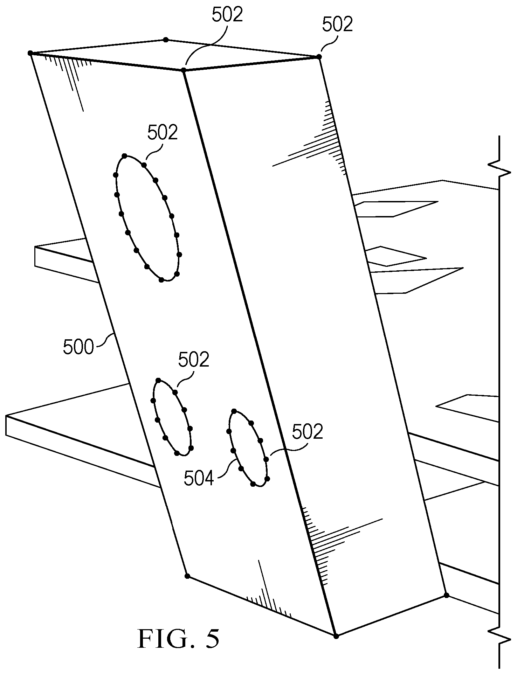

**Figure 1** is a block diagram of a daxle system depicted in accordance with an illustrative embodiment. Daxle system **100** receives input of a 3D object **102** such as a CAD (computer assisted design) model or image of a 3D object. Daxle system **100** identifies a number of key vertices **104** comprising the 3D object **102.** (See **Figure 5****).**

Daxle system **100** creates a number of bills of materials (BOM) **108** for the key vertices **104.** For each key vertex **106** among the key vertices **104,** daxle system **100** creates a respective BOM **110.** Each BOM **110** is enriched with additional data regarding its corresponding key vertex to generate an enriched 3D BOM **112.**

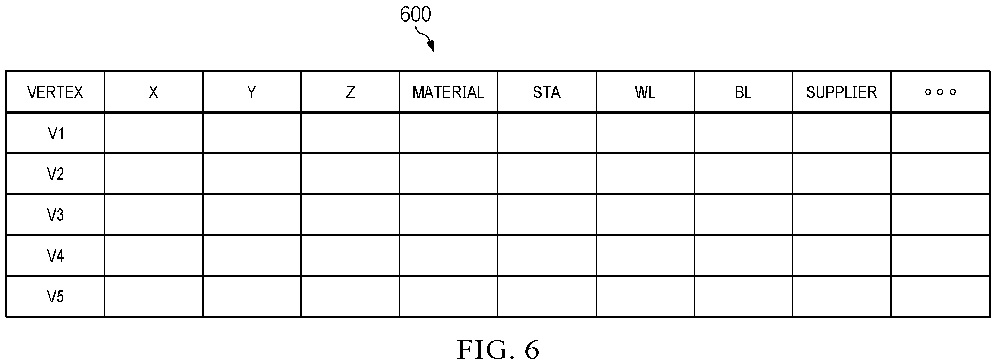

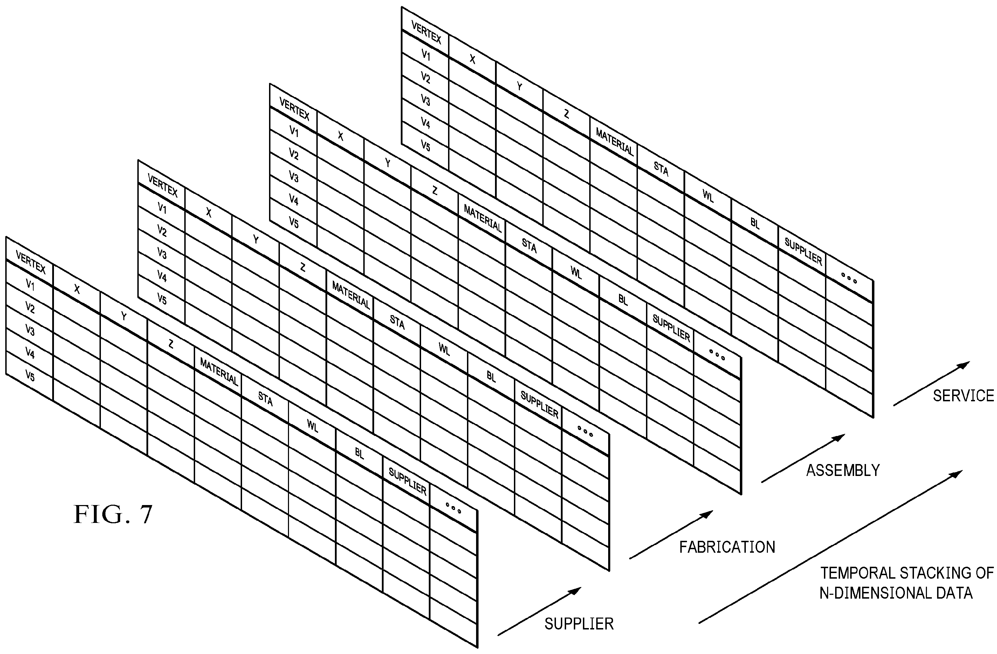

The additional data used to generate the enriched 3D BOM **112** is provided by a data accumulator **126** that draws from multiple data sources. One data source comprises production and manufacturing attributes **128,** which may include, e.g., materials used, supplier, cost, processing time, and inspection. (See **Figures 6** and **7****).** Data accumulator **126** might also add As Designed information **130** such as, e.g., surface roughness, a specified feature at the key vertex in question, and manufacturing instructions according to geometric references. The data accumulator might also add sensor data **132** to the enriched 3D BOM **112.** Examples of sensor data **132** include red, green, blue (RGB) image data, timestamp information, thermal imaging layers, humidity, and six degrees of freedom (6 DOF) tracking data.

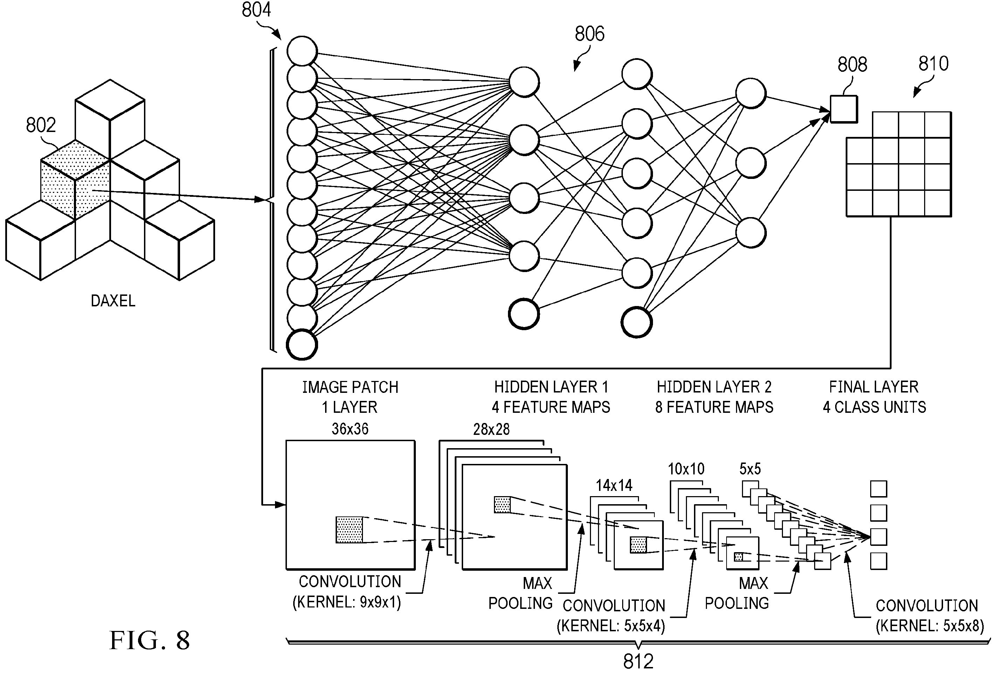

The enriched 3D BOMs **112** are fed into a number of data enriched neural networks **114.** (See **Figure 8****).** Each enriched 3D BOM **112** is fed into a respective data enriched neural network **116,** which generates a 2D pixel **118** that contains the enriched BOM data **120** that is contained in the enriched 3D BOM **112** but in a form that is more usable for machine learning.

The 2D pixel forms part of a 2D tensor **122** and can be fed to a downstream neural network **124** such as a convolutional neural network (CNN).

Daxle system **100** can be implemented in software, hardware, firmware, or a combination thereof. When software is used, the operations performed by daxle system **100** can be implemented in program code configured to run on hardware, such as a processor unit. When firmware is used, the operations performed by daxle system **100** can be implemented in program code and data and stored in persistent memory to run on a processor unit. When hardware is employed, the hardware can include circuits that operate to perform the operations in daxle system **100.**

In the illustrative examples, the hardware can take a form selected from at least one of a circuit system, an integrated circuit, an application specific integrated circuit (ASIC), a programmable logic device, or some other suitable type of hardware configured to perform a number of operations. With a programmable logic device, the device can be configured to perform the number of operations. The device can be reconfigured at a later time or can be permanently configured to perform the number of operations. Programmable logic devices include, for example, a programmable logic array, a programmable array logic, a field programmable logic array, a field programmable gate array, and other suitable hardware devices. Additionally, the processes can be implemented in organic components integrated with inorganic components and can be comprised entirely of organic components excluding a human being. For example, the processes can be implemented as circuits in organic semiconductors.

Computer system **150** is a physical hardware system and includes one or more data processing systems. When more than one data processing system is present in computer system **150,** those data processing systems are in communication with each other using a communications medium. The communications medium can be a network. The data processing systems can be selected from at least one of a computer, a server computer, a mobile device such as a tablet computer, or some other suitable data processing system.

As depicted, computer system **150** includes a number of processor units **152** that are capable of executing program code **154** implementing processes in the illustrative examples. As used herein, a processor unit in the number of processor units **152** is a hardware device and is comprised of hardware circuits such as those on an integrated circuit that respond and process instructions and program code that operate a computer. When a number of processor units **152** execute program code **154** for a process, the number of processor units **152** is one or more processor units that can be on the same computer or on different computers. In other words, the process can be distributed between processor units on the same or different computers in a computer system. Further, the number of processor units **152** can be of the same type or different types of processor units. For example, a number of processor units can be selected from at least one of a single core processor, a dual-core processor, a multi-processor core, a general-purpose central processing unit (CPU), a graphics processing unit (GPU), a digital signal processor (DSP), or some other type of processor unit.

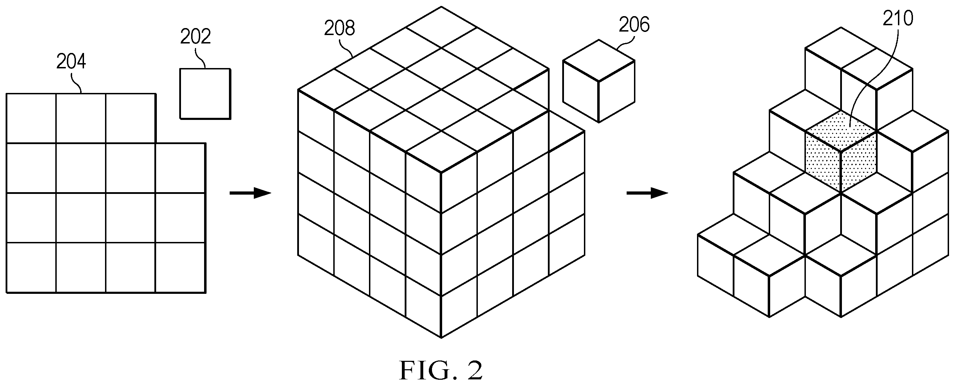

**Figure 2** depicts a diagram illustrating the relationship between different dimensional data representations in accordance with an illustrative embodiment. As shown, pixels (picture elements) **202** are typically used to represent two-dimensional (2D) visual data and are arranged in a 2D grid **204.**

A voxel (volumetric pixel) **206** is the three-dimensional equivalent of a 2D pixel **202.** A voxel **206** represents a point in 3D space. Voxels **206** are arranged in a 3D grid **208,** forming a volumetric representation of an object or space.

The illustrative embodiments incorporate additional data into a voxel to form a daxle **210,** which is an N-dimensional data enriched voxel. A daxle **210** is a data format that integrates diverse data streams into a unified structure. It encapsulates high-resolution images, accurate timestamps, thermal imaging layers, and 6 DOF tracking information within a single cohesive package. This combination empowers users to not only observe the visual appearance of a scene but also delve into its temporal aspects, thermal characteristics, and spatial dynamics. The fusion of these dimensions results in a holistic representation of the environment, fostering deeper insights and more informed decision-making.

Daxle **210** is comprised of encapsulated 3D BOMs with a temporal nature. Hence each 3D BOM **112** is a subset of a daxle **210** at one instance of time. Therefore, each 3D BOM **112** is a member of a daxle **210** that represents n-dimensional events and environments.

Conventional formats such as conventional pixels **202** and voxels **206** inadequately encapsulate a complete understanding of complex scenarios. Such existing formats often focus on a singular dimension, be it visual data, temporal information, or thermal imaging. However, many real-world applications demand a synthesis of these dimensions to comprehend scenarios comprehensively. For instance, in autonomous vehicle navigation, a single format that incorporates images, precise timestamps, thermal data, and 6 DOF tracking could enhance the vehicle's ability to interpret its surroundings accurately, especially in low-light conditions or challenging environments. The daxle format of the illustrative embodiments has applicability in various domains such as, e.g., robotics, surveillance, and environmental monitoring.

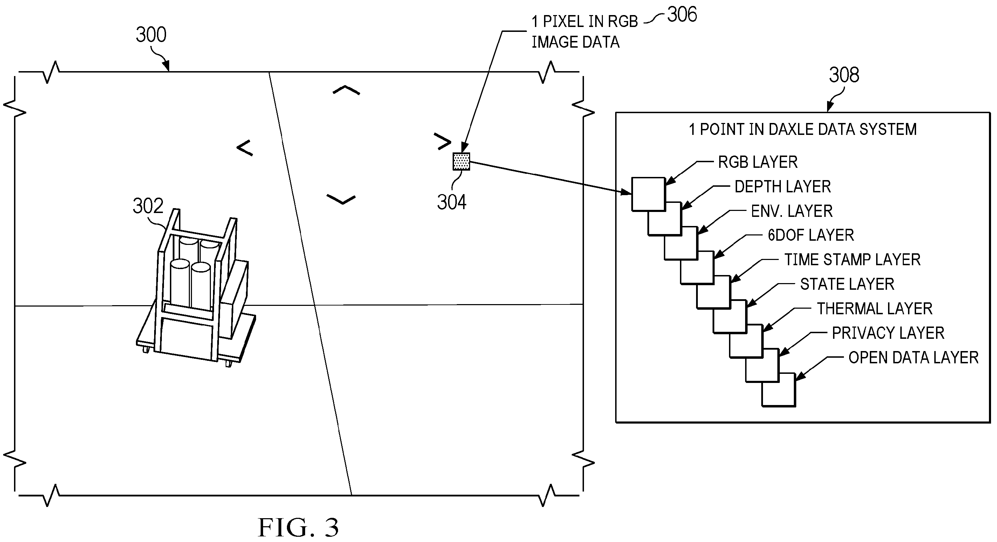

**Figure 3** depicts a diagram illustrating the contrast between pixel and daxle data representation in accordance with an illustrative embodiment. The present example shows an image **300** of a robot **302** on a factory floor.

A given point **304** in image **300** can be represented by a pixel **306** and a daxle **308.** The pixel **306** contains RGB data but does not, in itself, provide much context unless there is metadata or extra information to explain the image.

In contrast, in the present example, the daxle **308** includes not only an RGB layer of data but also a depth layer (3D depth), environment layer (where was the image captured), 6 DOF layer regarding the imaging device that captured the image, time stamp layer, state layer (e.g., taken during stage 1 of a production process), thermal layer (what was the temperature in the environment at the moment of image capture), privacy layer (granting or denying access to the image **300** or portion of the image per layer per pixel during a specific time frame and/or for specified users), and an open (variable) data layer to allow users to defined customized layers of particular types of data. Therefore, for each RGB pixel there is also an N-dimensional representation of contextual data accompanying that RGB pixel.

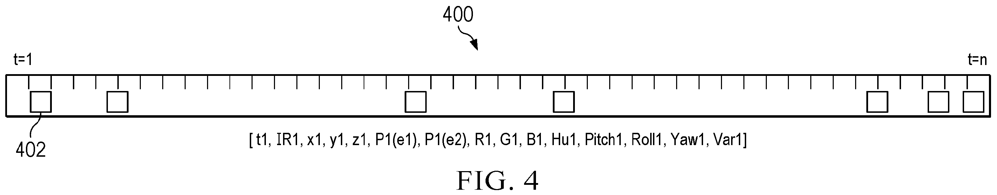

**Figure 4** depicts a diagram illustrating a temporal representation of an N-dimensional data format in accordance with an illustrative embodiment. The present example illustrates daxle values between timestamp value t=1 through t=n on time axis **400.**

In the present example, data point **402** at time t=1 is a 15-dimensional daxle that includes a time value (t1), infrared value (IR1), X-axis vale (x1), Y-axis value (y1), Z-axis value (z1), probability of event 1 happening at time t1 (P1(e1)), probability of event 2 happening at time t1 (P1(e2)), red value (R1), green value (G1), blue value (B1), humidity value (Hu1), pitch value (Pitch1), roll value (Roll1), yaw value (Yawl), and variable (open) layer value (Var1).

P1(e1) and P2(e2) might be generated from, e.g., production data, environmental data (e.g., changing shadows or light indicating an approaching object), or historical data. Var1 allows a user to add values to the daxle **402** such as, e.g., events, privacy settings, cost factors, etc., based on timestamp value. For example, Var1 can specify not showing a particular contour of an object throughout a supply chain timeframe. The system would then encrypt the data accordingly.

**Figure 5** depicts an example of a 3D CAD object from which a daxle can be generated in accordance with an illustrative embodiment. In model based instruction, manufacturing instructions are described in a specification document, e.g., apply a specific sealant at any sharp 90 degree edges, apply sealant around a drill hole (e.g., circle **504).** Such instructions can be extracted from the specifications, but to apply them, there needs to be a geometric reference with regard to the object **500,** which can be provided by daxles.

For 3D object **500,** the daxle system can detect a number of key vertices **502.** The number of key vertices might be greater or lesser in number according to the complexity of the object **500** and manufacturing instructions that need to be referenced to the geometry of the object. **Figure 6** depicts a table for creating a bill of materials for each key vertex of the 3D object **500** in accordance with an illustrative embodiment. Table **600** specifies a number of parameters for each identified key vertex of the object in question.

In the present example, for each key vertex V1-V2, table **600** specifies X, Y, Z values, material used, aircraft coordinate system (station (STA), water line (WL), butt line (BL)), supplier. Other metadata may be included in table **600** such as cost, what feature is supposed to be seen at that location (e.g., sealant, primer, decal) depending on production stage. Using the information in table **600,** a 3D bill of materials (BOM) is filled in for each key vertex based on production and manufacturing attributes to generate a daxle for each key vertex. **Figure 7** depicts temporal stacking of N-dimensional daxle data in accordance with an illustrative embodiment. Because daxles are multi-dimensional, they can be used to support temporal product lifecycle management (PLM).

In the present example, daxle data is shown according to different stages of a product cycle including original with the supplier, fabrication, assembly, and service. The BOM data comprising the daxles might change over time from one lifecycle stage to the next. For example, the material or inspection requirement might change from one stage to another. Similarly, processing time or cost might also change from one stage to another.

**Figure 8** depicts a diagram illustrating digestion of daxle data and its subsequent use in machine learning in accordance with an illustrative embodiment. In order to digest the multi-layer data per daxle, each daxle **802** is passed through a fully-connection input layer **804** of a data enriched neural network **806.**

Data enriched neural network **806** transforms the multi-layer N-dimensional data in the daxle **802** into a 2D pixel **808** that contains all the information of the daxle **802.** Data enriched neural network **806** is trainable so as not to lose any information during this transformation process and can use information present in the daxle **802** to predict the probability of missing values. For example, given 6 DOF and thermal data values, data enriched neural network **806** can predict a probably value for humidity if that value is missing from the daxle **802.** As such, data enriched neural network **806** represents a transition from data of a deterministic nature to data of a probabilistic nature.

This 2D pixel can form part of a 2D tensor **810** which can be used to train a downstream neural network **812** for AI and machine learning applications such as classification, feature generation, etc. Downstream neural network **812** might comprise, for example a CNN.

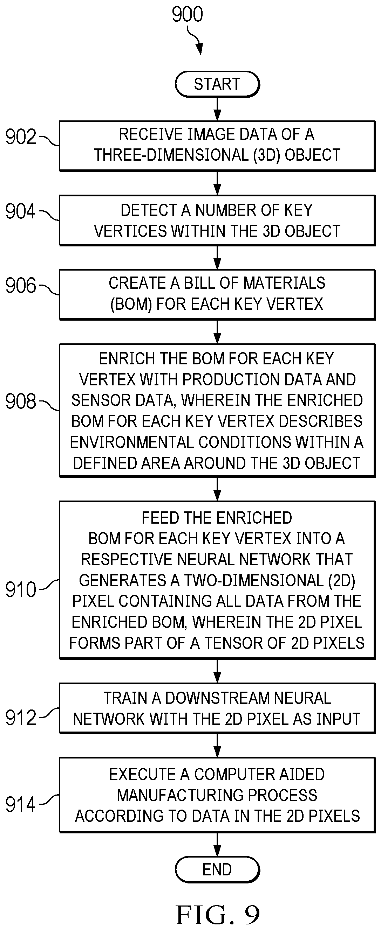

**Figure 9** depicts a flowchart illustrating a process for generating data enriched voxels in accordance with an illustrative embodiment. Process **900** can be implemented in daxle system **100** in **Figure 1****.**

Process **900** begins by receiving image data of a three-dimensional (3D) object (operation **902).** Process **900** detects a number of key vertices within the 3D object (operation **904).**

Process **900** creates a bill of materials (BOM) for each key vertex (operation **906)** and then enriches the BOM for each key vertex with production data and sensor data, wherein the enriched BOM for each key vertex describes environmental conditions within a defined area around the 3D object (operation **908).** The production data might comprise material used in manufacturing the 3D object, supplier, surface roughness, cost, processing time, inspection, specified feature at each location, airplane coordinate system data, and manufacturing instructions according to geometric references.

The sensor data might comprise RGB image data, timestamps, thermal imaging layers, humidity, 6 DOF tracking data (i.e., X, Y, Z coordinates and roll, pitch, and yaw). The enriched BOM might further comprise privacy data to restrict access to designated sensor data.

Process **900** feeds the enriched BOM for each key vertex into a respective neural network that generates a two-dimensional (2D) pixel containing all data from the enriched BOM, wherein the 2D pixel forms part of a tensor of 2D pixels (operation **910).** If a data value or values are missing from a given enriched BOM, its respective neural network can predict the missing data values based on other data values in that enriched BOM.

Process **900** might further comprise training a downstream neural network with the 2D pixel as input (operation **912**).

Process **900** executes a computer aided manufacturing process according to data in the 2D pixels (operation **914**).

Process **900** then ends.

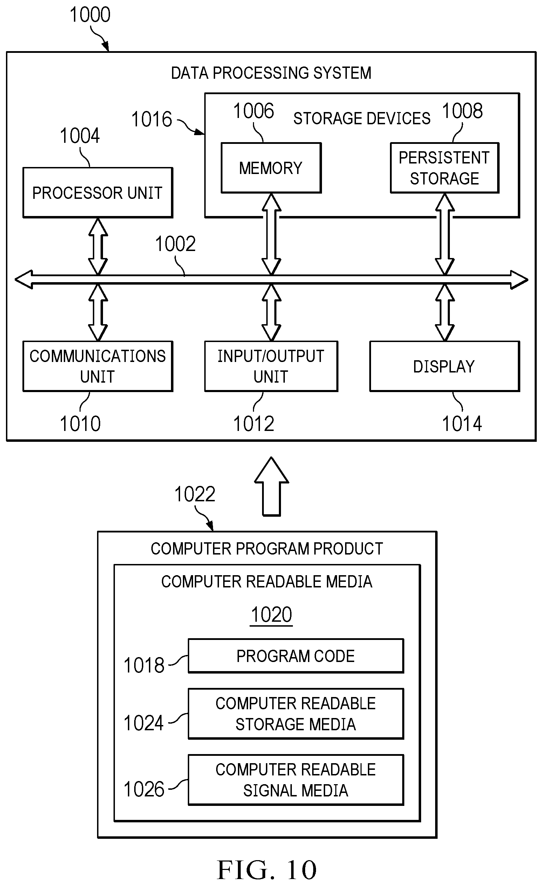

Turning now to **Figure 10****,** an illustration of a block diagram of a data processing system is depicted in accordance with an illustrative embodiment. Data processing system **1000** may be used to implement computer system **150** in **Figure 1****.** In this illustrative example, data processing system **1000** includes communications framework **1002,** which provides communications between processor unit **1004,** memory **1006,** persistent storage **1008,** communications unit **1010,** input/output (I/O) unit **1012,** and display **1014.** In this example, communications framework **1002** takes the form of a bus system.

Processor unit **1004** serves to execute instructions for software that may be loaded into memory **1006.** Processor unit **1004** may be a number of processors, a multi-processor core, or some other type of processor, depending on the particular implementation. In an embodiment, processor unit **1004** comprises one or more conventional general-purpose central processing units (CPUs). In an alternate embodiment, processor unit **1004** comprises one or more graphical processing units (GPUs). Memory **1006** and persistent storage **1008** are examples of storage devices **1016.** A storage device is any piece of hardware that is capable of storing information, such as, for example, without limitation, at least one of data, program code in functional form, or other suitable information either on a temporary basis, a permanent basis, or both on a temporary basis and a permanent basis. Storage devices **1016** may also be referred to as computer-readable storage devices in these illustrative examples. Memory **1006,** in these examples, may be, for example, a random access memory or any other suitable volatile or non-volatile storage device. Persistent storage **1008** may take various forms, depending on the particular implementation.

For example, persistent storage **1008** may contain one or more components or devices. For example, persistent storage **1008** may be a hard drive, a flash memory, a rewritable optical disk, a rewritable magnetic tape, or some combination of the above. The media used by persistent storage **1008** also may be removable. For example, a removable hard drive may be used for persistent storage **1008.** Communications unit **1010,** in these illustrative examples, provides for communications with other data processing systems or devices. In these illustrative examples, communications unit **1010** is a network interface card.

Input/output unit **1012** allows for input and output of data with other devices that may be connected to data processing system **1000.** For example, input/output unit **1012** may provide a connection for user input through at least one of a keyboard, a mouse, or some other suitable input device. Further, input/output unit **1012** may send output to a printer. Display **1014** provides a mechanism to display information to a user.

Instructions for at least one of the operating system, applications, or programs may be located in storage devices **1016,** which are in communication with processor unit **1004** through communications framework **1002.** The processes of the different embodiments may be performed by processor unit **1004** using computer-implemented instructions, which may be located in a memory, such as memory **1006.**

These instructions are referred to as program code, computer-usable program code, or computer-readable program code that may be read and executed by a processor in processor unit **1004.** The program code in the different embodiments may be embodied on different physical or computer-readable storage media, such as memory **1006** or persistent storage **1008.**

Program code **1018** is located in a functional form on computer-readable media **1020** that is selectively removable and may be loaded onto or transferred to data processing system **1000** for execution by processor unit **1004.** Program code **1018** and computer-readable media **1020** form computer program product **1022** in these illustrative examples. In one example, computer-readable media **1020** may be computer-readable storage media **1024** or computer-readable signal media **1026.**

In these illustrative examples, computer-readable storage media **1024** is a physical or tangible storage device used to store program code **1018** rather than a medium that propagates or transmits program code **1018.** Computer readable storage media **1024,** as used herein, is not to be construed as being transitory signals *per se,* such as radio waves or other freely propagating electromagnetic waves, electromagnetic waves propagating through a waveguide or other transmission media (e.g., light pulses passing through a fiber-optic cable), or electrical signals transmitted through a wire, as used herein, is not to be construed as being transitory signals *per se,* such as radio waves or other freely propagating electromagnetic waves, electromagnetic waves propagating through a waveguide or other transmission media (e.g., light pulses passing through a fiber-optic cable), or electrical signals transmitted through a wire. Alternatively, program code **1018** may be transferred to data processing system **1000** using computer-readable signal media **1026.** Computer-readable signal media **1026** may be, for example, a propagated data signal containing program code **1018.** For example, computer-readable signal media **1026** may be at least one of an electromagnetic signal, an optical signal, or any other suitable type of signal. These signals may be transmitted over at least one of communications links, such as wireless communications links, optical fiber cable, coaxial cable, a wire, or any other suitable type of communications link.

The different components illustrated for data processing system **1000** are not meant to provide architectural limitations to the manner in which different embodiments may be implemented. The different illustrative embodiments may be implemented in a data processing system including components in addition to or in place of those illustrated for data processing system **1000.** Other components shown in **Figure 10** can be varied from the illustrative examples shown. The different embodiments may be implemented using any hardware device or system capable of running program code **1018.**

As used herein, the phrase "at least one of," when used with a list of items, means different combinations of one or more of the listed items can be used, and only one of each item in the list may be needed. In other words, "at least one of" means any combination of items and number of items may be used from the list, but not all of the items in the list are required. The item can be a particular object, a thing, or a category.

For example, without limitation, "at least one of item A, item B, or item C" may include item A, item A and item B, or item B. This example also may include item A, item B, and item C or item B and item C. Of course, any combinations of these items can be present. In some illustrative examples, "at least one of" can be, for example, without limitation, two of item A; one of item B; and ten of item C; four of item B and seven of item C; or other suitable combinations.

As used herein, "a number of" when used with reference to items, means one or more items. For example, "a number of different types of networks" is one or more different types of networks. In illustrative example, a "set of" as used with reference items means one or more items.

For example, a set of metrics is one or more of the metrics.

The description of the different illustrative embodiments has been presented for purposes of illustration and description and is not intended to be exhaustive or limited to the embodiments in the form disclosed. The different illustrative examples describe components that perform actions or operations. In an illustrative embodiment, a component can be configured to perform the action or operation described. For example, the component can have a configuration or design for a structure that provides the component an ability to perform the action or operation that is described in the illustrative examples as being performed by the component. Further, to the extent that terms "includes", "including", "has", "contains", and variants thereof are used herein, such terms are intended to be inclusive in a manner similar to the term "comprises" as an open transition word without precluding any additional or other elements.

Many modifications and variations will be apparent to those of ordinary skill in the art. Further, different illustrative embodiments may provide different features as compared to other desirable embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

Further, the disclosure comprises configurations according to the following clauses.

Clause 1. A computer-implemented method for generating data enriched voxels, the method comprising:
using a number of processors to perform:
receiving (902) image data of a three-dimensional (3D) object (102);
detecting (904) a number of key vertices (104) within the 3D object;
creating (906) a bill of materials (BOM) (110) for each key vertex;
enriching (908) the BOM for each key vertex with production data (128, 130) and sensor data (132), wherein the enriched BOM for each key vertex describes environmental conditions within a defined area around the 3D object; and
feeding (910) the enriched BOM (112) for each key vertex into a respective neural network (116) that generates a two-dimensional (2D) pixel (118) containing all data from the enriched BOM, wherein the 2D pixel forms part of a tensor (122) of 2D pixels.

Clause 2. The method of Clause 1, further comprising training (912) a downstream neural network (124) with the 2D pixel as input.

Clause 3. The method of Clause 1, further comprising executing (914) a computer aided manufacturing process according to data in the 2D pixels.

Clause 4. The method of Clause 1, further comprising predicting, by a respective neural network, missing data values of an enriched BOM based on other data values in that enriched BOM.

Clause 5. The method of Clause 1, wherein the production data comprises at least one of:
material;
supplier;
surface roughness;
cost;
processing time;
inspection;
specified feature at each location;
airplane coordinate system data; or
manufacturing instructions according to geometric references.

Clause 6. The method of Clause 1, wherein the sensor data comprises at least one of:
red, green, blue (RGB);
timestamp;
thermal imaging layer;
humidity; or
six degrees of freedom (DOF) tracking data.

Clause 7. The method of Clause 1, wherein the enriched BOM further comprises privacy data to restrict access to designated sensor data.

Clause 8. A system for generating data enriched voxels, the system comprising:
a storage device that stores program instructions;
one or more processors operably connected to the storage device and configured to execute the program instructions to cause the system to:
   receive (902) image data of a three-dimensional (3D) object (102);
   detect (904) a number of key vertices (104) within the 3D object;
   create (906) a bill of materials (BOM) (110) for each key vertex;
   enrich (908) the BOM for each key vertex with production data (128, 130) and sensor data (132), wherein the enriched BOM for each key vertex describes environmental conditions within a defined area around the 3D object; and
   feed (910) the enriched BOM (112) for each key vertex into a respective neural network (116) that generates a two-dimensional (2D) pixel (118) containing all data from the enriched BOM, wherein the 2D pixel forms part of a tensor (122) of 2D pixels.

Clause 9. The system of Clause 8, wherein the processors further execute program instructions to train (912) a downstream neural network (124) with the 2D pixel as input.

Clause 10. The system of Clause 8, wherein the processors further execute program instructions to cause the system to execute (914) a computer aided manufacturing process according to data in the 2D pixels. Clause 11. The system of Clause 8, wherein the processors further execute program instructions to cause the system to predict, by a respective neural network, missing data values of an enriched BOM based on other data values in that enriched BOM.

Clause 12. The system of Clause 8, wherein the production data comprises at least one of:
material;
supplier;
surface roughness;
cost;
processing time;
inspection;
specified feature at each location;
airplane coordinate system data; or
manufacturing instructions according to geometric references.

Clause 13. The system of Clause 8, wherein the sensor data comprises at least one of:
red, green, blue (RGB);
timestamp;
thermal imaging layer;
humidity; or
six degrees of freedom (DOF) tracking data.

Clause 14. The system of Clause 8, wherein the enriched BOM further comprises privacy data to restrict access to designated sensor data.

Clause 15. A computer program product for generating data enriched voxels, the computer program product comprising:
a computer-readable storage medium having program instructions embodied thereon to perform the steps of:
receiving (902) image data of a three-dimensional (3D) object (102);
detecting (904) a number of key vertices (104) within the 3D object;
creating (906) a bill of materials (BOM) (110) for each key vertex;
enriching (908) the BOM for each key vertex with production data (128, 130) and sensor data (132), wherein the enriched BOM for each key vertex describes environmental conditions within a defined area around the 3D object; and
feeding (910) the enriched BOM (112) for each key vertex into a respective neural network (116) that generates a two-dimensional (2D) pixel (118) containing all data from the enriched BOM, wherein the 2D pixel forms part of a tensor (122) of 2D pixels.

Clause 16. The computer program product of Clause 15, further comprising instructions for training (912) a downstream neural network (124) with the 2D pixel as input.

Clause 17. The computer program product of Clause 15, further comprising instructions for executing (914) a computer aided manufacturing process according to data in the 2D pixels.

Clause 18. The computer program product of Clause 15, further comprising instructions for predicting, by a respective neural network, missing data values of an enriched BOM based on other data values in that enriched BOM.

Clause 19. The computer program product of Clause 15, wherein the production data comprises at least one of:
material;
supplier;
surface roughness;
cost;
processing time;
inspection;
specified feature at each location;
airplane coordinate system data; or
manufacturing instructions according to geometric references.

Clause 20. The computer program product of Clause 15, wherein the sensor data comprises at least one of:
red, green, blue (RGB);
timestamp;
thermal imaging layer;
humidity; or
six degrees of freedom (DOF) tracking data.

Clause 21. The computer program product of Clause 15, wherein the enriched BOM further comprises privacy data to restrict access to designated sensor data.

## Claims

1. A computer-implemented method (900) for generating data enriched voxels, the method (900) comprising:
using a number of processors to perform:
receiving (902) image data of a three-dimensional, 3D, object;
detecting (904) a number of key vertices within the 3D object;
creating (906) a bill of materials, BOM, (110) for each key vertex of the number of key vertices;
enriching (908) the BOM for each key vertex of the number of key vertices with production data and sensor dataso as to obtain an enriched 3D BOM, wherein the enriched 3D BOM for each key vertex of the number of key vertices describes environmental conditions within a defined area around the 3D object; and
feeding (910) the enriched 3D BOM for each key vertex of the number of key vertices into a respective neural network that is configured to generate a two-dimensional, 2D, pixel containing all data from the enriched 3D BOM, wherein the 2D pixel forms part of a 2D tensor of 2D pixels.

2. The method (900) of claim 1, further comprising training (912) a downstream neural network with the 2D pixel as input.

3. The method (900) of claim 1, further comprising executing (914) a computer aided manufacturing process according to data in the 2D pixels.

4. The method (900) of any one of the preceding claims, further comprising predicting, by said respective neural network, missing data values of the enriched 3D BOM based on other data values in that enriched 3D BOM.

5. The method (900) of any one of the preceding claims, wherein the production data comprises at least one of:
material;
supplier;
surface roughness;
cost;
processing time;
inspection;
specified feature at each location;
airplane coordinate system data; or
manufacturing instructions according to geometric references.

6. The method (900) of any one of the preceding claims, wherein the sensor data comprises at least one of:
red, green, blue, RGB;
timestamp;
thermal imaging layer;
humidity; or
six degrees of freedom, DOF, tracking data.

7. The method (900) of any one of the preceding claims, wherein the enriched 3D BOM further comprises privacy data to restrict access to designated sensor data.

8. A system (1000) for generating data enriched voxels, the system (1000) comprising:
a storage device (1016) configured to store program instructions;
one or more processors (1004) operably connected to the storage device (1016) and configured to execute the program instructions to cause the system (1000) to:
receive image data of a three-dimensional, 3D, object (102);
detect a number of key vertices (104) within the 3D object (102);
create a bill of materials, BOM, (110) for each key vertex (106) of the number of key vertices (104);
enrich the BOM (110) for each key vertex (106) of the number of key vertices (104) with production data (128, 130) and sensor data (132) so as to obtain an enriched 3D BOM (112), wherein the enriched 3D BOM (112) for each key vertex (106) of the number of key vertices (104) describes environmental conditions within a defined area around the 3D object (102); and
feed the enriched 3D BOM (112) for each key vertex (106) of the number of key vertices (104) into a respective neural network (116) that is configured to generate a two-dimensional, 2D, pixel (118) containing all data from the enriched 3D BOM (112), wherein the 2D pixel (112) forms part of a SD tensor (122) of 2D pixels.

9. The system (1000) of claim 8, wherein the one or more processors (1004) are further configured to execute program instructions to train a downstream neural network (124) with the 2D pixel (112) as input.

10. The system (1000) of claim 8, wherein the one or more processors (1004) are further configured to execute program instructions to cause the system (1000) to execute a computer aided manufacturing process according to data in the 2D pixels.

11. The system (1000) of any one of claims 8 to 10, wherein the one or more processors (1004) are further configured to execute program instructions to cause the system (1000) to predict, by the respective neural network (116), missing data values of the enriched 3D BOM (112) based on other data values in that enriched 3D BOM (112).

12. The system (1000) of any one of claims 8 to 11, wherein the production data (128, 130) comprises at least one of:
material;
supplier;
surface roughness;
cost;
processing time;
inspection;
specified feature at each location;
airplane coordinate system data; or
manufacturing instructions according to geometric references.

13. The system (1000) of any one of claims 8 to 12, wherein the sensor data (132) comprises at least one of:
red, green, blue, RGB;
timestamp;
thermal imaging layer;
humidity; or
six degrees of freedom, DOF, tracking data.

14. The system (1000) of any one of claims 8 to 13, wherein the enriched 3D BOM (112) further comprises privacy data to restrict access to designated sensor data.

15. A computer program product for generating data enriched voxels, the computer program product comprising:
a computer-readable storage medium having program instructions embodied thereon to perform the method (900) according to any one of claims 1 to 7.
